(19) Europäisches Patentamt
European Patent Office
Office européen des brevets

(11) **EP 3 943 955 B1**

(12) **FASCICULE DE BREVET EUROPEEN**

(45) Date de publication et mention
de la délivrance du brevet:
**26.06.2024 Bulletin 2024/26**

(21) Numéro de dépôt: **21187392.2**

(22) Date de dépôt: **23.07.2021**

(51) Classification Internationale des Brevets (IPC):
**G01R 27/18** *(2006.01)* **G01R 31/08** *(2020.01)*
**G01R 27/16** *(2006.01)* **G01R 31/52** *(2020.01)*

(52) Classification Coopérative des Brevets (CPC):
**G01R 31/086; G01R 27/16; G01R 27/18;
G01R 31/088; G01R 31/52**

(54) **PROCÉDÉS, DISPOSITIFS ET SYSTÈMES POUR DÉTECTER UN DÉFAUT D'ISOLEMENT DANS UNE INSTALLATION ÉLECTRIQUE**

VERFAHREN, VORRICHTUNGEN UND SYSTEME ZUR DETEKTION EINES ISOLATIONSFEHLERS IN EINER ELEKTRISCHEN ANLAGE

METHODS, DEVICES AND SYSTEMS FOR DETECTING AN INSULATION FAULT IN AN ELECTRICAL INSTALLATION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **24.07.2020 FR 2007819**

(43) Date de publication de la demande:
**26.01.2022 Bulletin 2022/04**

(73) Titulaire: **Schneider Electric Industries SAS
92500 Rueil-Malmaison (FR)**

(72) Inventeurs:
• **VINCENT, François
  38570 LE CHEYLAS (FR)**
• **STEPANEK, Jiri
  38400 SAINT MARTIN D'HERES (FR)**

(74) Mandataire: **Lavoix
62, rue de Bonnel
69448 Lyon Cedex 03 (FR)**

(56) Documents cités:
**EP-A1- 1 936 393      EP-A1- 2 006 694
CN-A- 101 526 578      FR-A1- 2 963 679
US-A- 5 140 492**

**EP 3 943 955 B1**

**Description**

La présente invention concerne des procédés et des dispositifs pour détecter un défaut d'isolement dans une installation électrique, notamment dans le domaine de la distribution d'électricité.

L'invention est tout particulièrement applicable aux installations électriques dans lesquelles les phases électriques et la ligne de neutre ne sont pas connectées à la terre (installations suivant un schéma de liaison à la terre de type IT).

Le document EP 2006694 A1 décrit un contrôleur permanent d'isolement pour détecter un défaut entre un conducteur électrique et la terre dans une installation électrique. Pour détecter un défaut, un courant est injecté dans l'installation électrique et une tension correspondante est mesurée pour déterminer une impédance du système en utilisant un système de mesure dédié.

Dans de telles installations, il est courant d'utiliser un système de détection dont le but est de détecter et de localiser des défauts d'isolement résultant d'une mise en contact inopinée entre une des phases (ou le neutre) et la terre.

En pratique, lorsqu'un tel défaut survient de façon isolée, il ne pose pas de danger immédiat pour l'installation, de sorte qu'il n'est pas nécessaire d'interrompre l'alimentation électrique tant qu'aucun autre défaut ne survient. Une fois le défaut localisé, un opérateur est dépêché sur place pour supprimer le problème à l'origine du défaut.

Par exemple, de tels systèmes de détection comportent un contrôleur d'isolement et des dispositifs de localisation connectés au niveau de chaque charge électrique alimentée par l'installation. Chacun des dispositifs de localisation est synchronisé avec le contrôleur d'isolement, par exemple en y étant raccordé par un câble ou par une liaison de communication.

Dans certaines installations, il peut être souhaitable de ne pas synchroniser le contrôleur d'isolement avec les dispositifs de localisation, afin de simplifier l'installation.

Toutefois, le système de détection peut alors, dans certaines circonstances, générer des fausses alertes, notamment lorsque le courant électrique a une faible intensité et en présence de certains phénomènes électriques.

De telles fausses alertes ne sont pas acceptables, car elles conduisent à mobiliser du personnel sans raison valable et peuvent affecter négativement le bon fonctionnement de l'installation et des appareils qu'elle alimente.

C'est à ces inconvénients qu'entend plus particulièrement remédier l'invention en proposant des procédés et des dispositifs pour détecter un défaut d'isolement dans une installation électrique.

A cet effet, un aspect de l'invention concerne un procédé pour détecter un défaut d'isolement dans une installation électrique selon la revendication 1.

Selon des aspects avantageux mais non obligatoires, un tel procédé de détection peut incorporer une ou plusieurs des caractéristiques suivantes, prises isolément ou suivant toute combinaison techniquement admissible :

- Le cas prédéterminé est également choisi en fonction des valeurs calculées de l'impédance du défaut électrique et de l'impédance de l'installation électrique.
- La sélection comporte une sous-étape de vérification des valeurs calculées de l'impédance du défaut électrique et de l'impédance de l'installation électrique pour détecter une valeur aberrante.
- Chacun des cas prédéterminés est associé à une ou plusieurs valeurs de courant de défaut et à une ou plusieurs valeurs de tension réseau qui correspondent à un état spécifique de l'installation, et dans lequel la sélection du cas prédéterminé comporte la sélection dudit cas qui correspond aux valeurs de courant de défaut et de tension réseau précédemment mesurées.
- La valeur d'impédance calculée est affichée par le dispositif de localisation et/ou est envoyée à distance par le dispositif de localisation.
- La deuxième fréquence est un multiple entier de la première fréquence.
- La deuxième fréquence est supérieure à la première fréquence.
- Préalablement à la mesure de tension, un premier appareil connecté entre la phase électrique de l'installation et la terre injecte un signal de mesure dans l'installation, le signal injecté comportant une composante oscillant périodiquement à la première fréquence et une composante oscillant périodiquement à la deuxième fréquence.

Selon un autre aspect, l'invention concerne un dispositif pour détecter un défaut d'isolement dans une installation électrique selon la revendication 9.

L'invention concerne également un Système de détection d'un défaut d'isolement dans une installation électrique, les phases électriques de l'installation étant normalement isolées de la terre, le système de détection comportant un premier appareil connecté entre une phase électrique de l'installation et la terre et un deuxième appareil associé à une charge électrique alimentée par l'installation électrique, le système de détection étant caractérisé en ce que le premier appareil est configuré pour injecter un signal de mesure dans l'installation. Le signal injecté comporte une première composante oscillant périodiquement à une première fréquence prédéfinie et une deuxième composante oscillant périodiquement à une deuxième fréquence prédéfinie. Le deuxième appareil est conforme au dispositif de détection.

L'invention sera mieux comprise et d'autres avantages de celle-ci apparaîtront plus clairement à la lumière de la description qui va suivre d'un mode de réalisation d'un procédé pour détecter un défaut d'isolement dans une installation électrique, donnée uniquement à titre d'exemple et faite en référence aux dessins annexés, dans lesquels :

[Fig 1] la figure 1 est un schéma d'une installation électrique comportant un système pour détecter un défaut d'isolement selon des modes de réalisation de l'invention ;
[Fig 2] la figure 2 est un schéma simplifié d'une portion de l'installation électrique et du système de détection de la figure 1 ;
[Fig 3] la figure 3 est un schéma simplifié d'une base de données utilisée par le système de détection de la figure 2 ;
[Fig 4] la figure 4 est un diagramme d'un procédé pour détecter un défaut d'isolement dans une installation électrique selon des modes de réalisation.

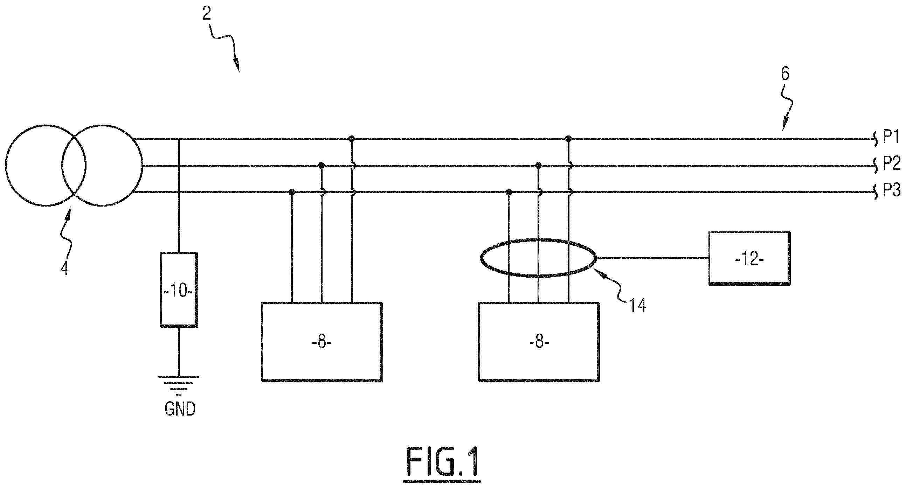

La figure 1 représente schématiquement une installation électrique 2, telle qu'une installation de distribution d'électricité.

L'installation 2 est alimentée par une source électrique 4, telle qu'un transformateur connecté à un réseau de distribution amont, ou un générateur.

L'installation 2 comporte un ou plusieurs conducteurs électriques 6 servant à acheminer un courant électrique, notamment un courant polyphasé, tel qu'un courant triphasé.

Dans l'exemple illustré, les conducteurs 6 sont respectivement associés à des phases électriques P1, P2 et P3, voire à une ligne de neutre (non illustrée sur la figure 1).

Par la suite, les conducteurs 6, qu'ils se rapportent aux phases P1, P2, P3 ou au neutre N, pourront être nommés « conducteurs de phase » ou « conducteurs actifs ».

Une ou plusieurs charges électriques 8 sont connectées aux conducteurs 6 et sont électriquement alimentées par l'installation 2. Par exemple, les charges électriques 8 sont des moteurs électriques, ou des machines industrielles, ou des systèmes de chauffage, ces exemples n'étant pas limitatifs.

Par exemple, les charges électriques 8 sont connectées aux conducteurs 6 au moyen de branchements ou de dérivations.

De préférence, dans l'installation 2, les phases électriques P1, P2 et P3 (et la ligne de neutre si celle-ci est présente) ne sont pas connectées à la terre dans des conditions normales de fonctionnement. Une telle installation 2 est dite présenter un schéma de liaison à la terre de type IT dans la nomenclature française.

L'installation 2 comporte également un système de détection configuré pour détecter un défaut d'isolement, notamment les défauts d'isolement résultant d'une mise en contact inopinée entre une des phases (ou le neutre) et la terre.

Le système de détection comprend un premier appareil 10, aussi nommé contrôleur d'isolement 10, et au moins un deuxième appareil 12, nommé dispositif de localisation 12, ou dispositif de détection.

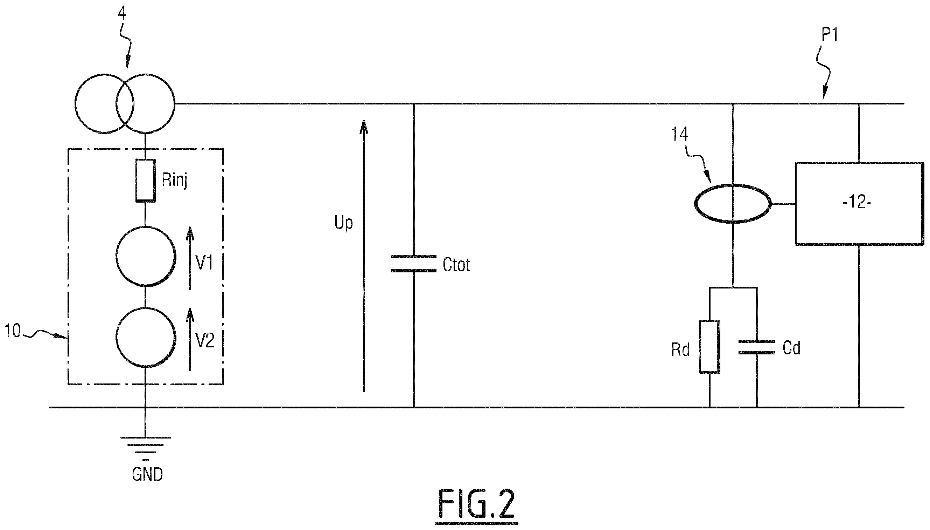

La figure 2 illustre un exemple d'implémentation du système de détection.

Le contrôleur d'isolement 10 est connecté entre les conducteurs 6 et la terre, de préférence au niveau de la source 4. Sur les figures 1 et 2, la terre est représentée par le symbole GND.

Pour simplifier la figure 2, le contrôleur d'isolement 10 est illustré connecté à une seule phase P1. En pratique, toutefois, le contrôleur d'isolement 10 peut être connecté à chacune des phases électriques et peut surveiller indépendamment chacune de ces phases. On comprend donc que la description qui est faite dans ce qui suit en référence à la seule phase P1 peut être généralisé à toutes les phases.

Le contrôleur d'isolement 10 est configuré pour injecter un courant électrique de mesure dans l'installation 2, aussi nommé « signal injecté » dans ce qui suit.

Par exemple, le contrôleur d'isolement 10 comporte un générateur de tension et une résistance $R_{inj}$ connectée entre la phase P1 à surveiller et la terre GND. Le courant de mesure est injecté dans la phase P1 en générant et appliquant une tension électrique entre la phase P1 et la terre GND.

En pratique, le courant injecté par le contrôleur d'isolement 10 se superpose au courant polyphasé délivré par la source 4.

Selon des exemples de réalisation, la tension générée par le contrôleur d'isolement 10 comprend au moins une composante alternative qui comporte une première composante V1 oscillant périodiquement à une première fréquence f1 et une deuxième composante V2 oscillant périodiquement à une deuxième fréquence f2.

Par exemple, la deuxième fréquence f2 est supérieure à la première fréquence f1.

De préférence, la deuxième fréquence f2 est un multiple entier de la première fréquence f1. Cela rend le signal injecté plus facile à mesurer par la suite, puisque les deux composantes V1 et V2 peuvent être mesurées avec le même pas d'échantillonnage.

Selon un exemple donné à des fins d'illustration, la première fréquence est égale à 1,25Hz et la deuxième fréquence f2 est égale à 2,5 Hz.

En particulier, les composantes V1 et V2 sont atténuées différemment lors de la propagation du signal injecté dans l'installation 2, ce qui au final permet de mieux détecter le signal injecté et de mesurer l'impédance de l'installation 2 de façon plus précise.

En variante, une ou plusieurs autres composantes additionnelles oscillant à des fréquences différentes pourraient être ajoutées à la tension générée par le contrôleur d'isolement 10. Les fréquences correspondantes sont alors de préférence supérieures à la deuxième fréquence f2 et sont des multiples de la fréquence f2.

La tension générée le contrôleur d'isolement 10 peut également comporter une composante continue, par exemple afin de rendre plus symétrique la tension générée.

De préférence, l'amplitude maximale de la tension générée est inférieure à 120V.

Dans de nombreux modes de réalisation, le contrôleur d'isolement 10 comporte un dispositif de commande implémenté par un ou plusieurs circuits électroniques.

Par exemple, le dispositif de commande comporte un processeur, tel qu'un microcontrôleur programmable ou un microprocesseur. Le processeur est couplé à une mémoire informatique, ou à tout support d'enregistrement de données lisible par ordinateur, qui comporte des instructions exécutables et/ou un code logiciel.

En variante, le dispositif de commande peut comporter un processeur de traitement du signal (DSP), ou un composant logique reprogrammable (FPGA), ou un circuit intégré spécialisé (ASIC), ou tout élément équivalent.

En pratique, le contrôleur d'isolement 10 peut également déterminer l'impédance globale de l'installation 2 et ainsi déterminer l'apparition d'un défaut d'isolement à l'échelle de l'installation 2. Toutefois, cela ne permet pas de savoir précisément à quel endroit de l'installation 2 se trouve le défaut, de sorte qu'il est alors utile, en complément, d'avoir recours aux dispositifs de localisation 12.

Chaque dispositif de localisation 12 est connecté au niveau d'une charge électrique 8 à surveiller. De préférence, un dispositif de localisation 12 est associé à chaque charge électrique 8 alimentée par l'installation 2

Chaque dispositif de localisation 12 comporte un dispositif de mesure 14 pour mesurer un courant électrique de défaut circulant entre la charge 8 surveillée et la terre, et plus exactement, entre les conducteurs de phase connectant cette charge électrique 8 et la terre.

Par exemple, un capteur de courant, tel qu'un tore de mesure ou équivalent, est couplé au branchement par lequel la charge 8 est connectée aux conducteurs 6.

Le dispositif de localisation 12 est également configuré pour mesurer la tension électrique, dite tension réseau, ou tension de ligne, notée Up dans ce qui suit, entre les phases électriques et la terre, par exemple au moyen d'un capteur de tension connecté entre une des phases électriques de la charge 8 (ici la phase P1) et la terre.

La tension réseau Up est, par exemple, imposée par le contrôleur d'isolement 10.

De préférence, le dispositif de localisation 12 est configuré pour mesurer la somme vectorielle de tous les courants de phase (et de neutre, le cas échéant) circulant dans les conducteurs de phase associés à la charge électrique 8 surveillée.

Pour simplifier la figure 2, un seul dispositif de localisation 12 est illustré, associé à la seule phase P1. De même que précédemment, en variante, le dispositif de localisation 12 peut être connecté à chacune des phases électriques et peut surveiller la charge électrique 8. Là encore, tout ce qui est expliqué en référence à la seule phase P1 peut être généralisé à toutes les phases électriques de l'installation.

En pratique, l'impédance de fuite de toute la charge électrique 8 (et donc pour tous les conducteurs de phase associés à cette charge électrique 8) peut être surveillée par le dispositif de localisation 12.

Par exemple, cette surveillance peut être rendue possible par le fait que le signal émis par le contrôleur d'isolement 10 se propage à partir du point de l'injection vers tous les conducteurs de phase au travers de la source 4, car l'impédance interne de la source 4, vue par le contrôleur d'isolement 10, est faible par rapport à l'impédance de l'installation électrique 2.

Dans l'exemple illustré, un défaut d'isolement entre la phase P1 et la terre GND est représentée par une impédance de défaut Zd comportant une résistance de défaut $R_d$ connectée en parallèle d'une capacité de défaut $C_d$ entre la phase P1 et la terre GND. La capacité totale de l'installation 2 (ici pour la phase électrique surveillée P1) est représentée par une capacité globale $C_{tot}$.

Dans de nombreux modes de réalisation, chaque dispositif de localisation 12 comporte un dispositif de commande implémenté par un ou plusieurs circuits électroniques.

Par exemple, le dispositif de commande comporte un processeur, tel qu'un microcontrôleur programmable ou un microprocesseur.

Le processeur est couplé à une mémoire informatique, ou à tout support d'enregistrement de données lisible par ordinateur, qui comporte des instructions exécutables et/ou un code logiciel prévu pour mettre en oeuvre un procédé de détection d'un défaut électrique lorsque ces instructions sont exécutées par le processeur.

Selon des variantes, le dispositif de commande peut comporter un processeur de traitement du signal (DSP), ou un composant logique reprogrammable (FPGA), ou un circuit intégré spécialisé (ASIC), ou tout élément équivalent.

De préférence, chaque dispositif de localisation 12 comporte une interface utilisateur, comprenant par exemple un écran d'affichage et/ou des indicateurs lumineux, permettant d'afficher un message d'alerte, ou un message de diagnostic, ou encore une ou plusieurs grandeurs électriques calculées ou mesurées.

Dans certaines variantes, chaque dispositif de localisation 12 peut comporter une interface de communication permettant d'envoyer des données vers un équipement distant, tel qu'un serveur informatique ou un contrôleur logique programmable.

Selon des modes de réalisation, l'interface de communication peut être de type filaire, par exemple pour permettre une connexion à un bus de données filaire, tel qu'un bus de données compatible avec le standard Modbus.

Dans d'autres modes de réalisation, l'interface de communication peut être une interface de communication sans fil, par exemple pour établir une liaison radio de courte portée.

De préférence, les dispositifs de localisation 12 sont indépendants du contrôleur d'isolement 10, c'est-à-dire qu'ils ne sont pas directement connectés au contrôleur d'isolement 10. Notamment, les dispositifs de localisation 12 ne sont pas synchronisés avec le contrôleur d'isolement 10. L'absence de synchronisation rend le système de détection plus simple à installer et à gérer par l'utilisateur.

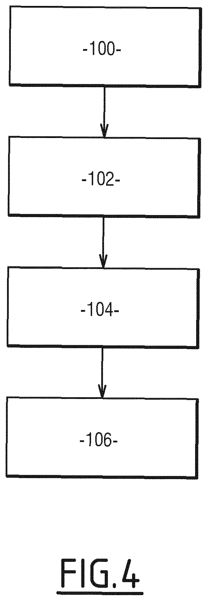

De façon générale, comme illustré par le schéma de la figure 4, chacun des dispositifs de localisation 12 est configuré pour :

- mesurer un courant de défaut entre la charge électrique 8 à surveiller et la terre GND, et pour mesurer la tension réseau Up entre les conducteurs de phase de la charge 8 à surveiller et la terre (étape 100) ;
- calculer l'impédance du défaut électrique Zd à partir des mesures du courant de défaut et de la tension réseau (étape 102) ;
- calculer l'impédance totale Zg de l'installation 2 à partir des mesures de la tension réseau, et en connaissant les paramètres du signal injecté par le contrôleur d'isolement 10, notamment les fréquences f1 et f2 et les amplitudes maximales de la première tension V1 et de la deuxième tension V2 (étape 102) ;
- sélectionner automatiquement un cas prédéterminé en fonction de la tension réseau mesurée et du courant de défaut mesuré (étape 104), voire également en fonction de l'impédance du défaut électrique Zd et de l'impédance globale Zg de l'installation précédemment calculées ;
- identifier une condition de l'installation 2, notamment une condition de défaut ou une condition de fonctionnement normal, à partir du cas sélectionné (étape 106).

Dans certaines variantes, certaines des étapes décrites ci-dessus pourraient être exécutées dans un ordre différent, voire être omises ou remplacées par des étapes fonctionnellement équivalentes. L'exemple décrit ne fait pas obstacle à ce que, dans d'autres modes de réalisation, d'autres étapes soient mises en oeuvre conjointement et/ou séquentiellement avec les étapes décrites.

Par exemple, à l'étape 100, la tension de ligne mesurée par le dispositif de localisation 12 reflète au moins en partie le signal injecté par le contrôleur d'isolement 10, et contient ainsi une première composante périodique oscillant à la première fréquence f1 et une deuxième composante oscillant à la deuxième fréquence f2.

Selon des exemples, ces deux composantes peuvent être mesurées par détection synchrone, étant entendu que les valeurs des première et deuxième fréquences f1 et f2 sont connues à l'avance par le dispositif de localisation 12. Par exemple, ces valeurs sont enregistrées dans une mémoire du dispositif de localisation 12.

En connaissant les première et deuxième tensions V1 et V2 ainsi que la valeur de la résistance d'injection $R_{inj}$ du contrôleur d'isolement 10, il est possible de déterminer l'impédance Zg de l'installation 2 sans nécessairement connaître le déphasage du signal injecté par le contrôleur d'isolement 10 par rapport au courant mesuré par le dispositif de localisation 12.

En d'autres termes, chaque dispositif de localisation 12 est capable de déterminer l'impédance Zg sans avoir besoin d'obtenir cette information en temps réel auprès du contrôleur d'isolement 10. Le système de détection est donc plus simple (et moins coûteux) à fabriquer et plus simple à mettre en oeuvre. On comprend ici que, dans les variantes où le signal injecté par le contrôleur d'isolement 10 comporte d'autres composantes de fréquences différentes en plus des première et deuxièmes composantes, comme envisagé ci-dessus, alors le dispositif de localisation 12 peut avantageusement être configuré pour déterminer l'impédance Zg de l'installation 2 en tenant aussi compte de ces composantes additionnelles et de leurs fréquences correspondantes.

De plus, en calculant localement l'impédance Zg de l'installation 2 au moyen du dispositif de localisation 12, il est possible de détecter une anomalie dans le fonctionnement du dispositif de localisation 12, par exemple si celui-ci calcule une valeur aberrante de l'impédance Zg, ce qu'il n'est pas possible de faire si l'impédance globale étant calculée par le contrôleur d'isolement 10 puis simplement transmise au dispositif de localisation 12.

Selon des modes de mise en oeuvre, lors de l'étape 102, l'impédance Zg de l'installation 2 est calculée à partir de la formule suivante :

$$\frac{1}{Zg} = \frac{1}{Rg} + j.\,2\pi.\,fr.\,Cg$$

où Rg est la partie réelle de l'impédance Zg, correspondant à la résistance globale de l'installation 2, Cg est la partie imaginaire de l'impédance Zg, correspondant à la capacité globale de l'installation 2, fr est la fréquence du réseau (ici égale à 50 Hz) et « j » est le nombre imaginaire.

Par exemple, la capacité globale Cg est calculée au moyen de la formule suivante :

$$Cg = \frac{1}{2\pi.\,f1.\,\sqrt{q^2 - 1}} \cdot \sqrt{\frac{\left(\frac{U2}{Rinj}\right)^2}{U_{d2r}^2 + U_{d2i}^2} - \frac{\left(\frac{U1}{Rinj}\right)^2}{U_{d1r}^2 + U_{d1i}^2}}$$

où « q » est le rapport entre la deuxième fréquence f2, et la première fréquence f1, $R_{inj}$ est la résistance d'injection du contrôleur d'isolement 10, U1 et U2 sont respectivement les amplitudes maximales des première et deuxième composantes de la tension générée par le contrôleur d'isolement 10, $U_{d1r}$ et $U_{d2r}$ sont respectivement les amplitudes maximales des première et deuxième composantes de la tension de ligne mesurée par le dispositif de localisation 12, et $U_{d1i}$ et $U_{d2i}$ sont respectivement les parties imaginaires des amplitudes maximales des première et deuxième composantes de la tension de ligne mesurée par le dispositif de localisation 12.

En pratique, les valeurs des amplitudes U1, U2 et de la résistance d'injection $R_{inj}$ sont connues à l'avance et peuvent être enregistrées dans une mémoire du dispositif de localisation 12, par exemple en usine ou lors de la mise en service de l'installation 2.

Par exemple, la résistance Cg est calculée au moyen de la formule suivante :

$$Rg = \frac{1}{\sqrt{\frac{1}{q^2 - 1} \cdot \left[\frac{q^2 \cdot \left(\frac{U1}{Rinj}\right)^2}{U_{d1r}^2 + U_{d1i}^2} - \frac{\left(\frac{U2}{Rinj}\right)^2}{U_{d2r}^2 + U_{d2i}^2}\right] - \frac{1}{Rinj}}}$$

où « q » est le rapport entre la deuxième fréquence f2, et la première fréquence f1, $R_{inj}$ est la résistance d'injection du contrôleur d'isolement 10, U1 et U2 sont respectivement les amplitudes maximales des première et deuxième composantes de la tension générée par le contrôleur d'isolement 10, $U_{d1r}$ et $U_{d2r}$ sont respectivement les parties réelles des amplitudes maximales des première et deuxième composantes de la tension de ligne mesurée par le dispositif de localisation 12, et $U_{d1i}$ et $U_{d2i}$ sont respectivement les parties imaginaires des amplitudes maximales des première et deuxième composantes de la tension de ligne mesurée par le dispositif de localisation 12.

En pratique, la somme des carrés $U_{d1r}^2 + U_{d1i}^2$ est égale au carré de l'amplitude de la première composante de fréquence f1 de la tension de ligne mesurée, qui peut être obtenue à partir de la tension mesurée (amplitude RMS).

Il en va de même pour la somme $U_{d2r}^2 + U_{d2i}^2$ avec la deuxième composante de fréquence f2.

Selon des modes de réalisation, lors de l'étape 102, l'impédance du défaut Zr est calculée à partir du courant de défaut mesuré par le capteur 14 et de la tension de ligne.

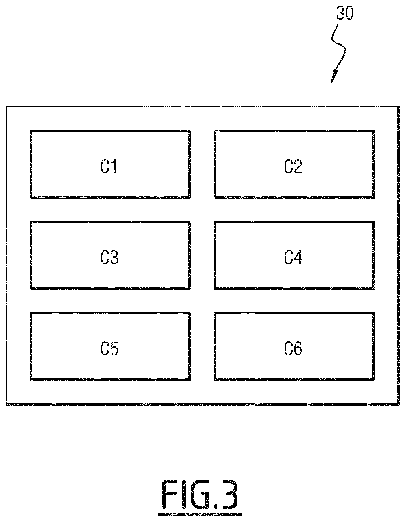

La figure 3 représente schématiquement une liste 30 comprenant une pluralité de cas prédéterminés, qui dans l'exemple illustré sont notés C1 à C6. En pratique, le nombre de cas prédéterminés stockés dans la table peut être différent de six. Dans l'exemple commenté ci-après, neuf cas sont prédéfinis, ce nombre pouvant être adapté en fonction des circonstances.

Par exemple, la liste 30 peut être enregistrée dans la mémoire du dispositif de localisation 12 sous toute forme appropriée, par exemple sous forme de table, ou de base de données, ou de toute structure de donnée équivalente.

Chacun des cas prédéterminés est associé à une ou plusieurs valeurs (par exemple un premier intervalle de valeurs) de courant de défaut et à une ou plusieurs valeurs (par exemple un deuxième intervalle de valeurs) de tension réseau qui correspondent à un état spécifique de l'installation, telle qu'une condition de fonctionnement normale ou une condition de défaut d'isolement, par exemple.

En d'autres termes, chacun des cas prédéterminés est indexé par des valeurs de courant de défaut et de tension réseau. Par exemple, un cas prédéterminé est associé à chaque combinaison d'intervalles de courant de défaut et de tension de ligne mesurée.

Par exemple, chacun des cas prédéterminés peut être défini par le constructeur lors de la fabrication du dispositif de localisation 12, ou par un installateur lors de la mise en service du dispositif de localisation 12 dans l'installation 2. La liste prédéfinie 30 est alors enregistrée en mémoire à ce moment là.

Lors de l'étape 104, un des cas prédéterminés est sélectionné en identifiant le cas prédéterminé dont les valeurs de courant et de tension correspondent à celles mesurées lors de l'étape 102. L'étape 106 consiste alors à retenir comme diagnostic la condition associée à ce cas prédéterminé sélectionné.

Lors de l'étape 106, le résultat du diagnostic peut être envoyé à distance et/ou affiché localement par l'interface du dispositif de localisation 12, par exemple en activant un ou plusieurs indicateurs lumineux et/ou en affichant un message ou un symbole sur l'écran d'affichage.

De préférence, la valeur d'impédance totale Zg calculée est affichée sur l'écran d'affichage du dispositif de localisation 12. Avantageusement, la valeur d'impédance du défaut Zd calculée est affichée sur l'écran d'affichage du dispositif de localisation 12

Dans certains modes de réalisation, chacun des cas prédéterminés est également associé à une ou des valeurs d'impédance globale Zg et/ou d'impédance de défaut Zd.

De préférence, l'étape 104 comporte une sous-étape de vérification pour détecter si les valeurs précédemment calculées d'impédance du défaut Zd et d'impédance totale Zg présentent une valeur aberrante indiquant une défaillance du système de détection ou une erreur de calcul, ou une erreur de mesure.

Par exemple, les valeurs d'impédance totale Zg et d'impédance de défaut Zd sont comparées l'une avec l'autre. Si l'impédance totale Zg de toute l'installation 2 est supérieure à l'impédance du défaut Zd, alors on considère qu'il s'agit d'une situation aberrante résultant d'une erreur de calcul, ou d'une erreur de mesure, ou d'un dysfonctionnement du système de détection.

Dans le cas où une telle valeur aberrante est identifiée, le procédé peut être interrompu. Un message d'alerte spécifique peut être affiché et/ou envoyé par le dispositif de localisation 12. En variante, le dispositif de localisation 12 peut inhiber l'affichage de la valeur d'impédance de défaut calculée et/ou la valeur d'impédance totale Zg calculée afin de ne pas induire en erreur un opérateur qui viendrait à consulter l'écran d'affichage.

Cette sous-étape de vérification peut être implémentée au début de l'étape 104, ou bien seulement après qu'un cas prédéterminé ait été sélectionné à partir des valeurs de courant et de tension mesurées.

Selon un exemple plus général donné à des fins d'illustration, la liste 30 comporte neuf cas prédéterminés, qui sont définis comme suit.

On définit trois intervalles de valeurs de courant de défaut Id (par exemple, inférieur à 0,1 mA, supérieur à 1mA et compris entre 0,1mA et 1mA) et trois intervalles de valeurs de tension de ligne $U_P$ (par exemple, inférieure à 100mV, supérieur à 5V et compris entre 0,1V et 5V) et un cas prédéterminé est associé à chaque combinaison de ces intervalles, comme résumé dans le tableau ci-après.

[Tableau 1]

|  | Up ≤ 100mV | 100mV < Up < 5V | Up ≥ 5V |
|---|---|---|---|
| Id ≤ 0,1 mA | Cas 1 | Cas 2 | Cas 3 |
| 0,1 mA < Id < 1mA | Cas 4 | Cas 5 | Cas 6 |
| Id ≥ 1mA | Cas 7 | Cas 8 | Cas 9 |

Dans cet exemple, pour les cas 1 et 2, le courant est faible, ce qui tend à indiquer que le défaut ne se trouve donc probablement pas au niveau de ce dispositif de localisation 12. Mais la tension de ligne Up est faible, probablement à cause d'un défaut d'isolement ailleurs dans l'installation. Le diagnostic associé à ces cas correspond donc à une absence de défaut à cet emplacement.

Pour le cas 3, la tension est suffisamment élevée, mais l'amplitude du courant est faible, ce qui indique que le défaut ne se trouve probablement pas à cet endroit. Le diagnostic associé correspond donc à une absence de défaut à cet emplacement.

Au vu des valeurs considérées, le rapport de la valeur de tension sur la valeur de courant devrait donner une impédance de défaut Zd supérieure à l'impédance globale Zg.

Si toutefois la vérification des valeurs de Zg et de Zd réalisée lors de cette étape 104 indique que l'impédance de défaut Zd est en fait inférieure à l'impédance globale Zg, alors le diagnostic associé à ce cas est ignoré et on considère qu'un dysfonctionnement s'est produit.

Pour le cas 4, la tension est trop faible par rapport à la valeur attendue, probablement à cause d'un défaut ailleurs dans l'installation. Le signal du courant présente une amplitude moyenne, indiquant que le défaut peut se trouver au moins en partie au niveau de la charge 8 associée au dispositif de localisation 12.

Les cas 5 et 6 correspondent à un cas normal du fonctionnement de l'installation 2, dans lequel un défaut d'isolement moyen est détecté au niveau de la charge électrique 8 surveillée. Là encore, l'impédance totale Zg ne devrait pas être plus grande que l'impédance du défaut Zd, sauf en cas de défaillance du dispositif de localisation 12.

Les cas 7 et 8 correspondent à un cas où un défaut d'isolement affecte l'installation 2 et se situe probablement sur le départ surveillé.

Le cas 9 indique une installation 2 très perturbée. Arriver dans ces conditions n'est théoriquement pas possible sauf le cas d'une fausse mesure. Même si l'impédance du défaut Zd est évaluée comme plus grande que l'impédance totale Zg, sa valeur n'est pas fiable, le client en devrait être prévenu.

Là encore, cet exemple n'est pas limitatif et les cas prédéfinis pourraient être définis différemment, en fonction des spécificités de l'installation 2.

Grâce à l'invention, les dispositifs de localisation 12 permettent de localiser efficacement un défaut d'isolement dans l'installation 2 sans avoir besoin d'être synchronisés avec le contrôleur d'isolement 10. Malgré cette absence de synchronisation, le procédé permet d'identifier la condition de l'installation (défaut ou fonctionnement normal) en limitant l'occurrence de fausses alertes.

En effet, dans certaines installations, la nature de la charge électrique 8 et la façon dont elle était pilotée est parfois susceptible de causer un faux positif détecté à tort par le dispositif de localisation 12. Un tel comportement a, par exemple, pu être observé avec un outil industriel alimenté par des trains d'impulsions de courant à basse fréquence (proche de 1 Hz). En l'absence de synchronisation entre le contrôleur d'isolement 10 et le dispositif de localisation 12, ce dernier confondait ces impulsions de courant avec le signal injecté par le contrôleur d'isolement 10, à cause d'une similitude entre ces signaux.

En réalisant le diagnostic à partir de cas prédéterminés que l'on sélectionne en fonction du courant et de la tension mesurés et des impédances calculées, le dispositif de détection 12 peut tenir compte de spécificités propres à chaque installation électrique.

Les dispositifs de détection 12 existants peuvent ainsi être reparamétrés et leur fonctionnement peut être adapté sans avoir besoin de modifier l'architecture de tout le système de détection, et sans avoir besoin de rajouter une synchronisation avec le contrôleur d'isolement 10, car celle-ci n'est pas adaptée ni souhaitable dans certaines installations.

Enfin, le fait de calculer l'impédance totale Zg au niveau des dispositifs de détection 12, plutôt que de réaliser ce calcul par le contrôleur d'isolement 10 puis de l'envoyer aux dispositifs de détection 12, permet d'identifier une défaillance du dispositif de détection 12.

Toute caractéristique de l'un des modes de réalisation ou variante décrite ci-dessus, peut être mise en oeuvre dans les autres modes de réalisation et variantes décrits.

## Revendications

1. Procédé pour détecter un défaut d'isolement dans une installation électrique (2) au moyen d'un dispositif de détection (12) associé à une charge électrique (8) alimentée par l'installation électrique, l'installation électrique (2) comportant un contrôleur d'isolement (10) configuré pour injecter un signal de mesure dans l'installation électrique (2), ledit signal injecté comportant une première composante (V1) oscillant périodiquement à une première fréquence prédéfinie (f1) et une deuxième composante (V2) oscillant périodiquement à une deuxième fréquence prédéfinie (f2), les phases électriques (P1, P2, P3, N) de l'installation étant normalement isolées de la terre, le procédé comportant des étapes consistant à :

   - mesurer (100) une tension électrique alternative ($U_p$) entre des conducteurs de phase de la charge électrique (8) à surveiller et la terre, ainsi qu'un courant électrique de défaut circulant entre ladite charge électrique et la terre ;
   - identifier (100), dans la tension électrique ($U_p$) mesurée, au moins une première composante (U1) oscillant à la première fréquence prédéfinie (f1) et une deuxième composante (U2) oscillant à la deuxième fréquence prédéfinie (f2) ;
   - calculer (102) une impédance du défaut électrique (Zd) à partir des mesures du courant de défaut et de la tension électrique ($U_p$) mesurée ;
   - calculer (102) l'impédance totale de l'installation électrique (Zg) à partir des première et deuxième composantes identifiées dans la tension électrique mesurée ;
   - sélectionner (104) un cas prédéterminé parmi une liste prédéfinie (30), en fonction des impédances calculées, de la tension électrique mesurée et du courant de défaut mesuré ;
- identifier (106) une condition de fonctionnement de l'installation électrique (2) en fonction du cas prédéterminé sélectionné.

2. Procédé selon la revendication 1, dans lequel le cas prédéterminé est également choisi en fonction des valeurs calculées de l'impédance du défaut électrique (Zd) et de l'impédance totale de l'installation électrique (Zg).

3. Procédé selon la revendication 1, dans lequel la sélection (104) comporte une sous-étape de vérification des valeurs calculées de l'impédance du défaut électrique et de l'impédance totale de l'installation électrique (Zg) pour détecter une valeur aberrante

4. Procédé selon l'une quelconque des revendications précédentes, dans lequel chacun des cas prédéterminés est associé à une ou plusieurs valeurs de courant de défaut et à une ou plusieurs valeurs de tension réseau qui correspondent à un état spécifique de l'installation, et dans lequel la sélection (104) du cas prédéterminé comporte la sélection dudit cas qui correspond aux valeurs de courant de défaut et de tension électrique précédemment mesurées.

5. Procédé selon l'une quelconque des revendications précédentes, dans lequel la valeur d'impédance calculée est affichée par le dispositif de localisation (12) et/ou est envoyée à distance par le dispositif de localisation (12).

6. Procédé selon l'une quelconque des revendications précédentes, dans lequel la deuxième fréquence (f2) est un multiple entier de la première fréquence (f1).

7. Procédé selon l'une quelconque des revendications précédentes, dans lequel la deuxième fréquence (f2) est supérieure à la première fréquence (f1).

8. Procédé selon l'une quelconque des revendications précédentes, dans lequel, préalablement à la mesure de tension, un premier appareil (10) connecté entre la phase électrique (P1) de l'installation (2) et la terre injecte un signal de mesure dans l'installation, le signal injecté comportant une composante (V1) oscillant périodiquement à la première fréquence (f1) et une composante (V2) oscillant périodiquement à la deuxième fréquence (f2).

9. Dispositif (12) pour détecter un défaut d'isolement dans une installation électrique (2), **caractérisé en ce que** ce dispositif est configuré pour mettre en oeuvre des étapes consistant à :

- mesurer (100) une tension électrique alternative ($U_p$) entre des conducteurs de phase de la charge électrique (8) à surveiller et la terre ainsi qu'un courant électrique de défaut circulant entre ladite charge électrique et la terre ;
- identifier (100), dans la tension électrique mesurée, au moins une première composante oscillant à une première fréquence prédéfinie (f1) et une deuxième composante oscillant à une deuxième fréquence prédéfinie (f2) ;
- calculer (102) une impédance du défaut électrique (Zd) à partir des mesures du courant de défaut et de la tension électrique ($U_p$) mesurée ;
- calculer (102) l'impédance totale de l'installation électrique (Zg) à partir des première et deuxième composantes identifiées dans la tension électrique mesurée ;
- sélectionner (104) un cas prédéterminé parmi une liste prédéfinie (30), en fonction des impédances calculées, de la tension électrique mesurée et du courant de défaut mesuré ;
- identifier (106) une condition de fonctionnement de l'installation électrique (2) en fonction du cas prédéterminé sélectionné.

10. Système de détection d'un défaut d'isolement dans une installation électrique (2), les phases électriques (P1, P2, P3, N) de l'installation étant normalement isolées de la terre, le système de détection comportant un premier appareil (10) connecté entre une phase électrique (P1) de l'installation (2) et la terre et un deuxième appareil (12) associé à une charge électrique (8) alimentée par l'installation électrique, le système de détection étant **caractérisé en ce que** le premier appareil est configuré pour injecter un signal de mesure dans l'installation, ledit signal injecté comportant une première composante (V1) oscillant périodiquement à une première fréquence prédéfinie (f1) et une deuxième composante (V2) oscillant périodiquement à une deuxième fréquence prédéfinie (f2), et **en ce que** le deuxième appareil est conforme au dispositif de détection (12) de la revendication 9.

**Patentansprüche**

1. Verfahren zum Erfassen eines Isolationsfehlers in einer elektrischen Anlage (2) mittels einer Erfassungsvorrichtung (12), die mit einer elektrischen Last (8) verbunden ist, die von der elektrischen Anlage gespeist wird, die elektrische Anlage (2) umfassend einen Isolationswächter (10), der so konfiguriert ist, dass er ein Messsignal in die elektrische Anlage (2) einspeist, wobei das eingespeiste Signal eine erste Komponente (V1), die periodisch mit einer ersten vordefinierten Frequenz (f1) schwingt, und eine zweite Komponente (V2), die periodisch mit einer zweiten vordefinierten Frequenz (f2) schwingt, umfasst, wobei die elektrischen Phasen (P1, P2, P3, N) der Anlage normalerweise von der Erde isoliert sind, wobei das Verfahren die folgenden Schritte umfasst:

   - Messen (100) einer elektrischen Wechselspannung ($U_p$) zwischen Phasenleitern der zu überwachenden elektrischen Last (8) und der Erde sowie eines elektrischen Fehlerstroms, der zwischen der genannten elektrischen Last und der Erde fließt;
   - Identifizieren (100), in der gemessenen elektrischen Spannung ($U_p$), mindestens einer ersten Komponente (U1), die mit der ersten vordefinierten Frequenz (f1) schwingt und einer zweiten Komponente (U2), die mit der zweiten vordefinierten Frequenz (f2) schwingt;
   - Berechnen (102) einer Impedanz des elektrischen Fehlers (Zd) aus den Messungen des Fehlerstroms und der gemessenen elektrischen Spannung ($U_p$);
   - Berechnen (102) der Gesamtimpedanz der elektrischen Anlage (Zg) aus der ersten und der zweiten Komponente, die in der gemessenen elektrischen Spannung identifiziert wurden;
   - Auswählen (104) eines vorbestimmten Falls aus einer vordefinierten Liste (30), basierend auf den berechneten Impedanzen, der gemessenen elektrischen Spannung und dem gemessenen Fehlerstrom;
   - Identifizieren (106) eines Betriebszustands der elektrischen Anlage (2) in Abhängigkeit von dem ausgewählten vorbestimmten Fall.

2. Verfahren nach Anspruch 1, wobei der vorbestimmte Fall auch in Abhängigkeit von den berechneten Werten der Impedanz des elektrischen Fehlers (Zd) und der Gesamtimpedanz der elektrischen Anlage (Zg) ausgewählt wird.

3. Verfahren nach Anspruch 1, wobei die Auswahl (104) einen Unterschritt des Überprüfens der berechneten Werte der Impedanz des elektrischen Fehlers und der Gesamtimpedanz der elektrischen Anlage (Zg) umfasst, um einen Ausreißer zu erkennen.

4. Verfahren nach einem der vorhergehenden Ansprüche, bei dem jeder der vorbestimmten Fälle mit einem oder mehreren Fehlerstromwerten und einem oder mehreren Netzspannungswerten verbunden ist, die einem spezifischen Zustand der Anlage entsprechen, und wobei die Auswahl (104) des vorbestimmten Falls die Auswahl desjenigen Falls umfasst, der den zuvor gemessenen Werten des Fehlerstroms und der Netzspannung entspricht.

5. Verfahren nach einem der vorhergehenden Ansprüche, bei dem der berechnete Impedanzwert von der Ortungsvorrichtung (12) angezeigt und/oder von der Ortungsvorrichtung (12) ferngesendet wird.

6. Verfahren nach einem der vorhergehenden Ansprüche, wobei die zweite Frequenz (f2) ein ganzzahliges Vielfaches der ersten Frequenz (f1) ist.

7. Verfahren nach einem der vorhergehenden Ansprüche, wobei die zweite Frequenz (f2) höher als die erste Frequenz (f1) ist.

8. Verfahren nach einem der vorhergehenden Ansprüche, bei dem vor der Spannungsmessung ein erstes Gerät (10), das zwischen der elektrischen Phase (P1) der Anlage (2) und der Erde ein Messsignal in die Anlage einspeist, wobei das eingespeiste Signal eine Komponente (V1), die periodisch mit der ersten Frequenz (f1) schwingt, und eine Komponente (V2), die periodisch mit der zweiten Frequenz (f2) schwingt, umfasst.

9. Vorrichtung (12) zum Erkennen eines Isolationsfehlers in einer elektrischen Anlage (2), **dadurch gekennzeichnet, dass** diese Vorrichtung so konfiguriert ist, dass sie Schritte ausführt, die in Folgendem bestehen:

   - Messen (100) einer elektrischen Wechselspannung ($U_p$) zwischen Phasenleitern der zu überwachenden elektrischen Last (8) und der Erde sowie eines elektrischen Fehlerstroms, der zwischen der genannten elektrischen Last und der Erde fließt;
   - Identifizieren (100), in der gemessenen elektrischen Spannung, mindestens einer ersten Komponente, die mit einer ersten vordefinierten Frequenz (f1) schwingt, und einer zweiten Komponente, die mit einer zweiten vordefinierten Frequenz (f2) schwingt;
- Berechnen (102) einer Impedanz des elektrischen Fehlers (Zd) aus den Messungen des Fehlerstroms und der gemessenen elektrischen Spannung (U$_p$);
- Berechnen (102) der Gesamtimpedanz der elektrischen Anlage (Z$_g$) aus der ersten und der zweiten Komponente, die in der gemessenen elektrischen Spannung identifiziert wurden;
- Auswählen (104) eines vorbestimmten Falls aus einer vordefinierten Liste (30), basierend auf den berechneten Impedanzen, der gemessenen elektrischen Spannung und dem gemessenen Fehlerstrom;
- Identifizieren (106) eines Betriebszustands der elektrischen Anlage (2) in Abhängigkeit von dem ausgewählten vorbestimmten Fall.

10. System zur Erkennung eines Isolationsfehlers in einer elektrischen Anlage (2), wobei die elektrischen Phasen (P1, P2, P3, N) der Anlage normalerweise von der Erde isoliert sind, wobei das Erkennungssystem ein erstes Gerät (10) umfasst, das zwischen einer elektrischen Phase (P1) der Anlage (2) und der Erde und ein zweites Gerät (12), das mit einer elektrischen Last (8) verbunden ist, die von der elektrischen Anlage gespeist wird, wobei das Erfassungssystem **dadurch gekennzeichnet ist, dass** das erste Gerät so konfiguriert ist, dass es ein Messsignal in die Anlage einspeist, wobei das eingespeiste Signal eine erste Komponente (V1) umfasst, die periodisch mit einer ersten vordefinierten Frequenz (f1) schwingt und eine zweite Komponente (V2), die periodisch mit einer zweiten vordefinierten Frequenz (f2) schwingt, und dass das zweite Gerät der Erfassungsvorrichtung (12) nach Anspruch 9 entspricht.

**Claims**

1. Method for detecting an isolation fault in an electrical installation (2) by means of a detecting device (12) associated with an electrical load (8) supplied by the electrical installation, the electrical installation (2) comprising an isolation monitor (10) configured to inject a measurement signal into the electrical installation (2), said injected signal comprising a first component (V1) oscillating periodically at a predefined first frequency (f1) and a second component (V2) oscillating periodically at a predefined second frequency (f2), the electrical phases (P1, P2, P3, N) of the installation being normally isolated from ground, the method comprising steps consisting in:

   - measuring (100) an AC electrical voltage (U$_p$) between phase conductors of the electrical load (8) to be monitored and ground, and an electric fault current flowing between said electrical load and ground;
   - identifying (100), in the measured electrical voltage (Up), at least one first component (U1) oscillating at the predefined first frequency (f1) and one second component (U2) oscillating at the predefined second frequency (f2);
   - calculating (102) an impedance (Zd) of the electrical fault from the fault current measurements and from the measured electrical voltage (Up);
   - calculating (102) an overall impedance (Zg) of the electrical installation from the first and second components identified in the measured electrical voltage;
   - selecting (104) a predetermined case from a predefined list (30), depending on the calculated impedances, on the measured electrical voltage and on the measured fault current;
   - identifying (106) an operating condition of the electrical installation (2) on the basis of the selected predetermined case.

2. Method according to Claim 1, wherein the predetermined case is also chosen depending on the calculated values of the impedance (Zd) of the electrical fault and of the overall impedance (Zg) of the electrical installation.

3. Method according to Claim 1, wherein the step of selecting (104) comprises a sub-step of verifying the calculated values of the impedance of the electrical fault and of the overall impedance (Zg) of the electrical installation in order to detect an aberrant value.

4. Method according to any one of the preceding claims, wherein each of the predetermined cases is associated with one or more fault current values and with one or more network voltage values that correspond to a specific state of the installation, and wherein the step of selecting (104) the predetermined case comprises selecting said case that corresponds to the fault current and electrical voltage values measured beforehand.

5. Method according to any one of the preceding claims, wherein the calculated impedance value is displayed by the locating device (12) and/or is sent to a remote site by the locating device (12).

6. Method according to any one of the preceding claims, wherein the second frequency (f2) is an integer multiple of the first frequency (f1).

7. Method according to any one of the preceding claims, wherein the second frequency (f2) is higher than the first frequency (f1).

8. Method according to any one of the preceding claims, wherein, prior to the voltage measurement, a first apparatus (10) connected between the electrical phase (P1) of the installation (2) and ground injects a measurement signal into the installation, the injected signal comprising a component (V1) oscillating periodically at the first frequency (f1) and a component (V2) oscillating periodically at the second frequency (f2).

9. Device (12) for detecting an isolation fault in an electrical installation (2), **characterized in that** this device is configured to implement steps consisting in:

   - measuring (100) an AC electrical voltage (Up) between phase conductors of the electrical load (8) to be monitored and ground, and an electric fault current flowing between said electrical load and ground;
   - identifying (100), in the measured electrical voltage, at least one first component oscillating at a predefined first frequency (f1) and one second component oscillating at a predefined second frequency (f2);
   - calculating (102) an impedance (Zd) of the electrical fault from the fault current measurements and from the measured electrical voltage (Up);
   - calculating (102) an overall impedance (Zg) of the electrical installation from the first and second components identified in the measured electrical voltage;
   - selecting (104) a predetermined case from a predefined list (30), depending on the calculated impedances, on the measured electrical voltage and on the measured fault current;
   - identifying (106) an operating condition of the electrical installation (2) on the basis of the selected predetermined case.

10. System for detecting an isolation fault in an electrical installation (2), the electrical phases (P1, P2, P3, N) of the installation being normally isolated from ground, the detecting system comprising a first apparatus (10) connected between an electrical phase (P1) of the installation (2) and ground and a second apparatus (12) associated with an electrical load (8) supplied by the electrical installation, the detecting system being **characterized in that** the first apparatus is configured to inject a measurement signal into the installation, said injected signal comprising a first component (V1) oscillating periodically at a predefined first frequency (f1) and a second component (V2) oscillating periodically at a predefined second frequency (f2), and **in that** the second apparatus is according to the detecting device (12) of Claim 9.

FIG.1

EP 3 943 955 B1

$\underline{\text{FIG.2}}$

FIG.3

FIG.4

**EP 3 943 955 B1**

## RÉFÉRENCES CITÉES DANS LA DESCRIPTION

**Documents brevets cités dans la description**

- EP 2006694 A1